# EUROPEAN PATENT APPLICATION

(11) **EP 0 650 191 A1**
(43) Date of publication of application: **26.04.1995**
(21) Application number: 94118778.3
(22) Date of filing: 19.02.1992
(51) Int. Cl.: H01L 23/14, H01L 23/24, H01L 23/485, H01L 23/49, H01L 23/433

(54) **Structure of semiconductor IC chip**

(30) Priority: 20.02.1991 JP 24971/91
(62) Divisional of application: 92102759.5
(71) Applicant: NEC CORPORATION, Tokyo (JP)
(72) Inventor: Dohya, Akihiro, Minato-ku, Tokyo (JP)
(74) Representative: VOSSIUS & PARTNER

(57) **Abstract**

A structure of semiconductor IC (Integrated Circuit) chip carrier feasible for a multi-terminal arrangement and high-speed signal propagation. Input/output terminals in the form of pins (50a) having intermediate flanges are directly provided on the circuit surface of an IC chip (50) to serve as the leads of a chip carrier. A heat spreader (52) is soldered (54) or otherwise affixed to the rear of the IC chip and plays the role of the body of the chip carrier. The IC chip itself may be buried in the heat spreader by a seal resin (56).

## Description

The present invention relates to a semiconductor IC (Integrated Circuit) chip carrier and, more particularly, to a structure of a semiconductor IC chip carrier implementing a multi-terminal arrangement and high-speed signal propagation.

A semiconductor IC chip usually has input/output terminals in peripheral portions thereof and has such terminals connected to an external circuit board via a chip carrier on which the chip is mounted. This kind of chip carrier is disclosed in, for example, "Microelectronics Packaging Handbook" edited by Rao R. Tummala et al, page 531. The chip carrier taught in this document includes a lead frame carrying a semiconductor IC chip thereon and connected by lead wires to input/output terminals which are positioned in the peripheral portions of the chip. A plastic member covers the lead wires other than those connected to the circuit board in the peripheral portion, and the entire chip. Specifically, the chip having the input/output terminals in the peripheral portions thereof is mounted on the lead frame, and the lead frame connected to the input/output terminals is positioned in the peripheral portions of the chip carrier. Such a conventional structure is not feasible for a multi-terminal arrangement which is essential for high integration. This is because the conventional structure does not allow a great number of connecting terminals to be provided thereon, compared to a structure having connecting terminals to be connected to a circuit board on the major surface of a chip carrier, as distinguished from the peripheral portions. For example, assume that connecting terminals are provided on a 10 millimeters square chip carrier at a pitch of 0.5 millimeter. When connecting terminals are formed on the four sides of such a chip carrier, 20 terminals are provided on one side (10÷0.5=20) and, therefore, 80 terminals are provided in total. By contrast, when connecting terminals are formed on the major surface of the chip carrier at a pitch of 0.5 millimeter, 400 terminals are attainable (20 × 20 = 400). In light of this, a chip carrier called PGA (Pin Grid Array) is available, as taught in Japanese Utility Model Publication No. 5893/1989. However, even with a PGA type chip carrier having connecting terminals on the major surface thereof, the IC chip has the input/output terminals in the peripheral portions thereof and is, therefore, not satisfactory regarding the connection of the chip to the chip carrier.

A conventional chip carrier has a particular structure in which the input/ouptut terminals of an IC chip and the connecting terminals or leads of a chip carrier body are not contiguous each other. This kind of structure is disadvantageous in that the length as measured from the input/output terminals of the IC chip to the tip of the leads of the chip carrier is great, increasing inductance and capacitance which are electrical characteristic values. High inductance and capacitance are not desirable for high-speed signal propagation. Further, since the input/output terminals of the chip are connected to the leads of the chip carrier by wires, the number of points of connection is increased. This is problematic from the quality and reliability standpoint.

An IC chip may be directly connected to a circuit board or similar board without the intermediary of a chip carrier, as also disclosed in "Microelectronics Packaging Handbook", page 366. This kind of approach is referred to as bare chip packaging since the IC chip (called a flip chip) is mounted on a circuit board in a bare state. The flip chip has connecting terminals on the major surface thereof and is, therefore, feasible for a multi-terminal configuration. Since the input/output terminals of the chip themselves serve as the connecting terminals, they readily adapt to a multi-terminal configuration. A similar bare chip structure is proposed in Japanese Patent Application No. 305119/1987. This bare chip structure is such that micropins are formed on the circuit surface of a chip which is provided with a passivation film. The micropins replace solder bumps to reduce the stresses ascribable to a difference between the coefficient of thermal expansion of a circuit board and that of the IC chip.

The conventional bare chip packaging schemes described above have come problems left unsolved, compared to the structure in which an IC chip is mounted on a chip carrier. Specifically, while a chip carrier hermetically seals an IC chip to protect it against contamination, moisture and atmosphere, bare chip packaging has a bare chip which is critically susceptible to ambient conditions. Although bare chip packaging usually takes some protective measure at the level of a module, i.e., a circuit board carrying a plurality of chips, the protection is more complicated and difficult than the protection at the chip level. It is a common practice with an IC chip to check the quality thereof by electical checks and to screen it by bias tests before mounting it on a circuit board. Another problem is, therefore, that such operations are not easy to effect with the bare chip and are apt to contaminate or break up the chip. By contrast, a chip mounted on a chip carrier is easy to test and screen. Further, when a chip is mounted on a chip carrier, the chip carrier plays the role of a heat spreader and may even be provided with a heat sink for heat radiation. On the other hand. it is extremely difficult with the bare chip scheme to mount a heat sink directly on the chip. When a chip of the kind generating a great amount of heat is used in bare chip packaging, a special mechanism for heat radiation has to be used, resulting in an expensive system.

It is, therefore, an object of the present invention to provide a semiconductor IC chip carrier structure implementing a multi-terminal configuration and high-speed signal propagation.

It is another object of the present invention to provide a simple and inexpensive semiconductor IC chip carrier structure.

It is another object of the present invention to provide a semiconductor IC chip carrier structure which is reliable and easy to handle and maintain.

A semiconductor IC chip carrier of the present invention comprises a semiconductor IC chip, input/output terminals arranged on a circuit surface of the IC chip, and a heat spreader affixed to a surface of the IC chip opposite to the circuit surface.

The above and other objects, features and advantages of the present invention will become more apparent from the following detailed description taken with the accompanying drawings in which:
FIGS. 1 and 2 are sections each showing a conventional semiconductor IC chip carrier structure;
FIGS. 3 and 4 each shows a conventional bare chip packaging scheme;
FIG. 5 is a section showing a semiconductor IC chip carrier structure embodying the present invention;
FIG. 6 is a section showing a modified form of the chip carrier of FIG. 5;
FIG. 7 is a section showing an alternative embodiment of the present inventon;
FIG. 8 is a section showing a modified form of the chip carrier shown in FIG. 7;
FIG. 9 is a section showing another alternative embodiment of the present invention;
FIG. 10 is a section showing a modified form of the chip carrier shown in FIG. 9; and
FIG. 11 is a section showing another alternative embodiment of the present invention.

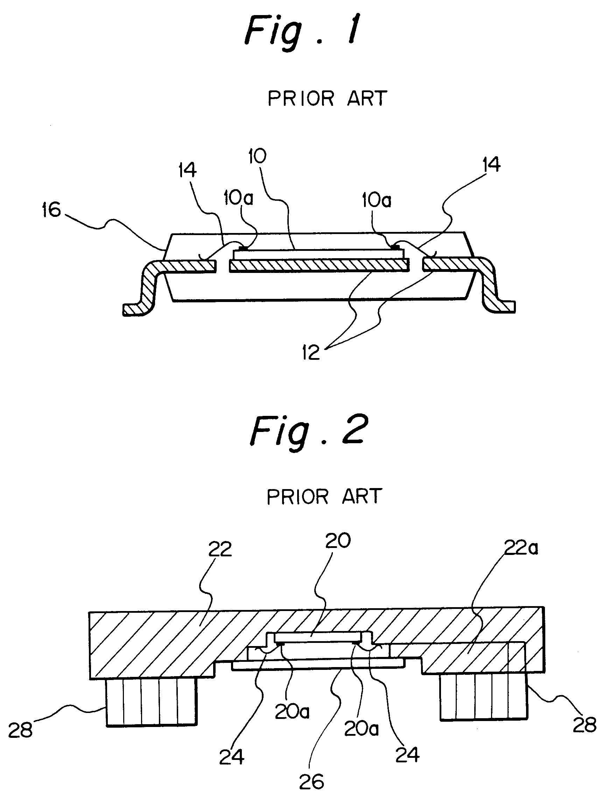

To better understand the present invention, a brief reference will be made to conventional semiconductor IC chip and chip carrier structures. FIG. 1 shows the chip carrier structure described in previously stated "Microelectronics Packaging Handbook", page 531. As shown, a chip carrier has a lead frame 12 mounting an IC chip 10 thereon, lead wires 14 connecting the input/output terminals 10a of the chip 10 and the lead frame 12, and a plastic member 16 covering the entire chip carrier. The chip carrier is connected to a circuit board, not shown, by the lead frame 12. Since the chip 10 has the input/output terminals 10a in the peripheral portions thereof and since the lead frame 12 connected to the input/output terminals 10a and circuit board, i.e., the connecting terminals to the outside are arranged in the peripheral portions of the chip carrier, such a chip carrier is not feasible for a multi-terminal arrangement which is essential for high integration of a chip.

FIG. 2 shows the structue of a PGA type chip carrier disclosed in previously mentioned Japanese Utility Model Laid-Open Publication No. 5893/1989. As shown, the chip carrier has a ceramic substrate 22 having a recess at the center thereof and an inner layer pattern 22a. An IC chip 20 having input/output terminals 20a is received in the recess of the substrate 22. Wires 24 connect the input/output terminals 20a of the chip 20 and the substrate 22. A lid covers the recess of the substate 22 to shield the chip 20. Connecting terminals 28 are affixed the same major surface of the substate 22 as the chip 20 and connected to a circuit board, not shown. While the PGA type chip carrier is provided with the connecting terminals 28 on the major surface of the carrier and not near the edges in order to implement the multi-terminal arrangement, the input/output terminals 20a of the chip 20 themselves are still positioned in the peripheral portions. Hence, regarding the multi-terminal configuration, the PGA type chip carrier scheme has a limit in respect of the connection of the chip 20 to the substrate 22 of the carrier.

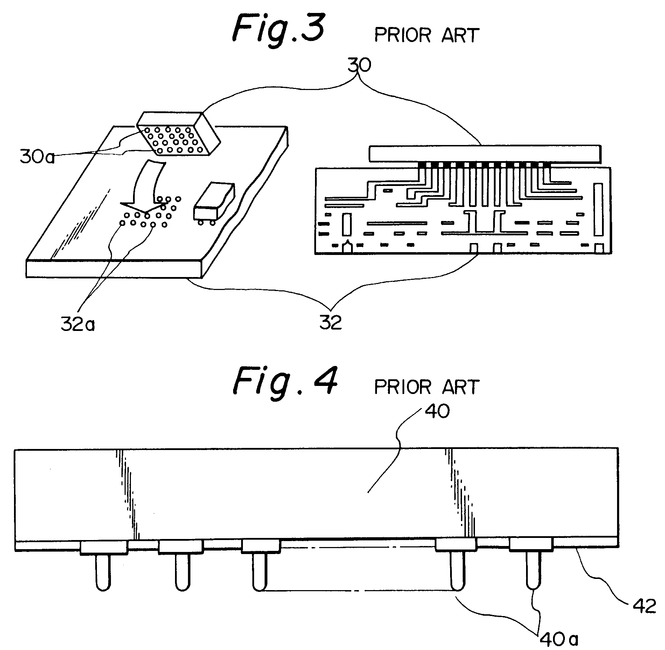

FIG. 3 shows a bare chip packaging scheme, i.e., a structure in which the IC chip is directly connected to a circuit board without the intermediary of a chip carrier, as also described in "Microelectronics Packaging Handbook", page 366. As shown, an IC chip 30 has input/output terminals 30a thereof directly connected to connecting terminals 32a provided on a circuit board 32. FIG. 4 shows a bare chip packing scheme taught in Japanese Patent Application No. 305119/1987. An IC chip 40 shown in FIG. 4 has a passivation film 42 on the circuit side thereof and input/output terminals in the form of micropins 40a formed on the circuit side. The micropins 40a play the role of connecting terminals to the outside. Bare chip packaging, however, has various problems regarding reliability, handling and heat radiation, compared to the structure wherein a chip is fitted on a chip carrier.

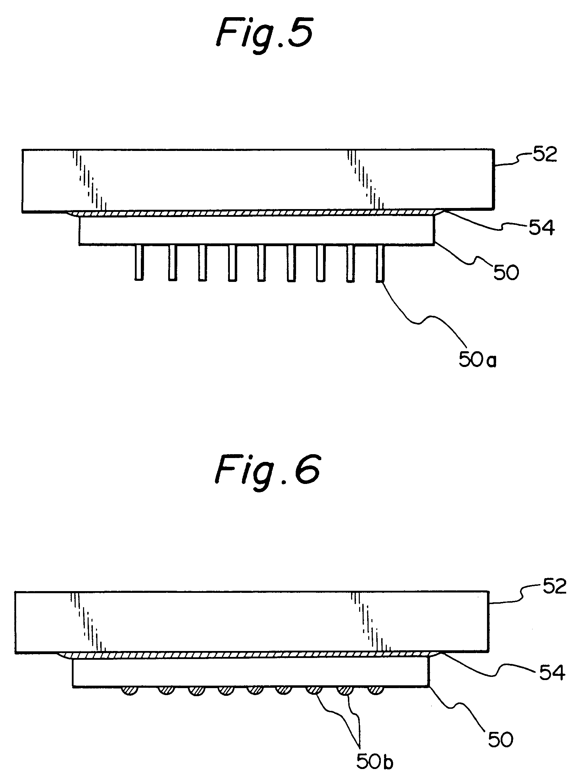

Referring to FIG. 5, an IC chip carrier structure embodying the present invention is shown. As shown, an IC chip 50 is affixed to a plate or heat spreader 52 by an adhering member 54. Pins 50a are formed on the circuit side of the chip 50 to serve as input/output pins. Specifically, lands are formed on the surface of the chip 50 by a thin film of metal, and the pins 50a are connected to the lands by a silver-tin soldering material.

The heat spreader 52 is dimensioned slightly greater than the IC chip 50. For example, assuming that the chip 50 is 10 millimeters square wide, the heat spreader 52 is 12 millimeters to 15 millimeters square wire. The heat spreader 52 is 0.5 millimeter to 2 millimeter wide. Preferably, the heat spreader 52 is made of a material which has great mechanical strength and high heat conductivity and has a coefficient of thermal expansion comparable with that of the chip 50. When the chip 50 is made of silicon, the heat spreader 52 may advantageously be made of aluminum nitride (AlN), silicon carbide (SiC), copper-tungsten (CuW), or aluminum alloy.

The IC chip 50 is affixed to the heat spreader 52 by, for example, gold-germanium or gold-tin solder, tin-lead solder, or silver-epoxy adhesive. The adhering member 54 is selected in matching relation to the material of the heat spreader 52 and the size of the chip 50. For example, if the chip 50 is less than 10 millimeters square wide, use may be made of gold-silicon solder since the chip 50 will sparingly crack against heat although the coefficient of thermal expansion of the heat spreader 52 may not be exactly the same as that of the chip 50. On the other hand, if the chip 50 is more than 10 millimeters square wide and the heat spreader 52 and chip 50 do not have the same coefficient of thermal expansion, Ag epoxy having a certain degree of plasticity is used as the adhering material 54. However, Ag epoxy is lower in thermal conductivity than solder. It follows that the best combination is a heat spreader 52 made of a material well matching in the coefficient of thermal expansion with the chip 50 and an adhering material 54 which is solder or similar metal.

The primary role of the heat spreader 52 is to receive heat from the IC chip 50 and radiate it over a broader area, thereby reducing the thermal resistance of the whole chip carrier. Assuming the chip 50 is dimensioned 10 millimeters square, the area is 100 square millimeters. Under this condition, assuming that the heat spreader 52 is dimensioned 14 millimeters square, the area is 196 square millimeters. The resulting heat radiation area is twice as broad as the heat radiation area without the heat spreader 52. Another role of the heat spreader 52 is to mechanically protect the chip 50. Specifically, the heat spreader 52 is expected to promote easy handling of the chip 50 in the event of inspection and mounting on a circuit board, to protect the chip 50 mounted on the circuit board, and to serve as a base for mounting a heat sink or similar cooling part. Especially, the chip 50 is mechanically weak alone and extremely difficult to handle, whether it be made of silicon or GaAs. The heat spreader 52 mechanically reinforces such a chip 50 and prevents it from being damaged in the event of electrical or mechaical tests of the chip, screening by bias tests, and mounting on a circuit board. In addition, the chip 50 can be held by the heat spreader 52. Moreover, if the heat spreader 52 is affixed to the chip 50 before the pins 50a, the pins 50a can be readily affixed to the chip 50 later. A further role of the heat spreader 52 is to position the chip 50 with accuracy. The material constituting the chip 50 is not only mechanically too fragile to withstand chipping, as stated earlier, but also irregular in size on tens of microns order. On the other hand, the heat spreader 52 can be made of a mechanically strong material and can be polished or otherwise machined to have dimensional accuracy of several microns order in terms of allowance. The chip 50 is affixed to the heat spreader 52 with the positions of the input/output terminals thereof held in register with predetermined positions. The words "positions of the input/output terminals" of the chip 50 will be the positions of the pins 50a if the latter has already been provided on the chip 50 or the positions of the lands for forming the pins 50a if otherwise. Then, the chip 50 can be accurately positioned by use of the heat spreader 52 when the pins 50a should be affixed or when the chip carrier should be mounted on a circuit board.

Lands are formed on the surface of the chip 50 by a thin film of metal, and the pins 50a are bonded to the lands by gold-tin solder, as stated earlier. Such a structure allows input/output terminals to be formed not only in the peripheral portions of the chip but also in the central area of the chip, implementing a multi-terminal configuration and high-speed signal propagation. The surface of the chip 50 is passivated by a silicon oxide (SiO₂) film, silicon nitride (SiNx) film, or polyimid film. The pins 50a each has a diameter of 0.05 millimeter to 0.2 millimeter and a length of 0.5 millimeter to 2 millimeters. Preferably, the pins 50a are made of copper, copper alloy, nickel, tungsten, or cobalt. The relative position of the pins 50a and heat spreader 52 is accurately determined. For example, the distance between the sides of the heat spreader 52 and the pins 50a lies in a small allowance.

While the input/output terminals of the chip 50 are implemented as pins in the embodiment, they may take the form of bumps 50b shown in FIG. 6.

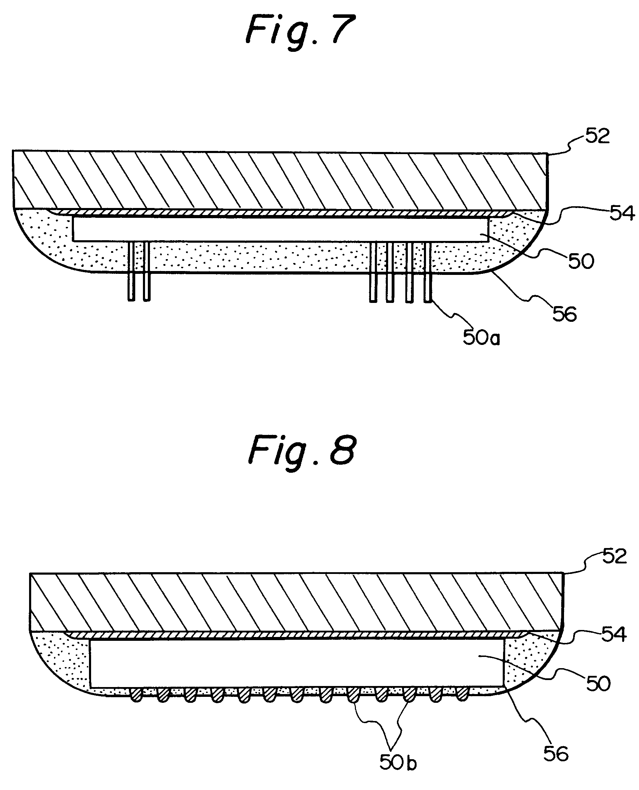

FIG. 7 shows an alternative embodiment of the present invention. As shown, the chip carrier has a seal resin 56 in addition to the components of the embodiment shown in FIG. 5. The seal resin 56 covers the IC chip 50, part of the heat spreader 52, and part of the pins 50a, providing the chip carrier with a hermetic structure. The seal resin 56 may be epoxy resin, polyimid resin, phenol resin, silicon resin, etc. To form the seal resin 56, use may be made of a potting method or a transfer mold method. The potting method is to apply a resin of low viscosity by using a dispenser and is less costly than the transfer mold method. However, the potting method needs precise control over thickness and shape and, therefore, thorough evaluation. In this embodiment, the seal resin 56 does not extend to the sides of the heat spreader 52, and the tips of the pins 50a protrude from the seal resin 56. This kind of configuration is relatively easy to fabricate by controlling the viscosity and quantity of the potting material.

The embodiment with the seal resin 56 is far more hermetic than the embodiment shown in FIG. 5. While the embodiment shown in FIG. 5 needs the passivation film on the surface of the chip 50, the embodiment of FIG. 7 does not need it since the seal resin 56 implements passivation. Preferably, however, even the chip 50 shown in FIG. 7 may be provided with a passivation film in addition to the seal resin 56 to enhance reliability. In the embodiment of FIG. 7, the leads extending out from the chip 50 directly serve as the leads of the chip carrier. This is in contrast to the conventional structure of FIG. 1 in which the leads from the chip and the leads of the chip carrier are independent of each other, and connections are effected within the chip carrier. This difference is extremely significant, as discussed earlier in relation to the prior art. Again, the input/output terminals of the chip 50 may be implemented as bumps 50b shown in FIG. 8.

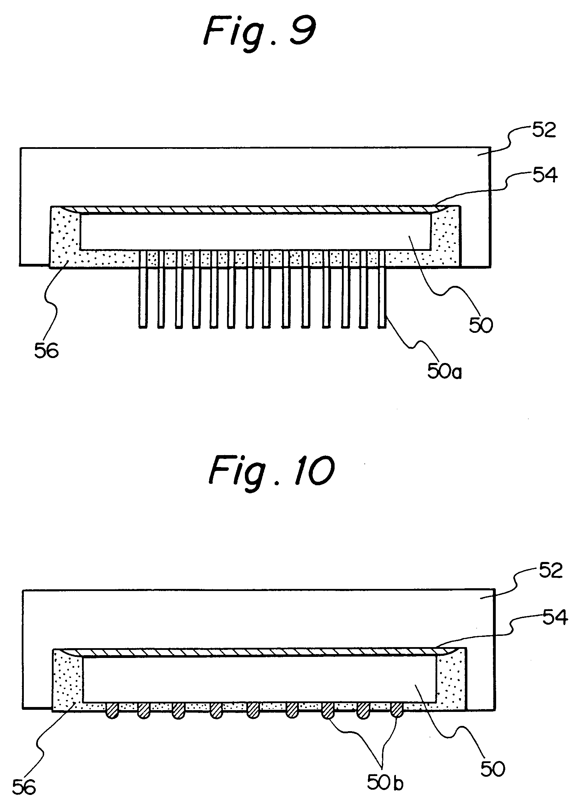

Referring to FIG. 9, another alternative embodiment of the present invention will be described. As shown, the heat spreader 52 has a recess for receiving the IC chip 50 in order to enhance the functions thereof. Specifically, regarding the heat radiating function, the recess reduces the distance between the rear of the chip 50 and the outer upper surface of the heat spreader 52 to thereby reduce the thermal resistance. Further, since the heat spreader 52 can be provided with broad outer periphery, heat radiation attainable therewith is excellent. In addition, the heat spreader 52 with the recess has greater mechanical strength than a flat plate having the same thickness. Another function, i.e., the mechanical protection of the chip 50 is also remarkably enhanced. If the depth of the recess is greater than the thickness of the chip 50, the heat spreader 52 will fully protect even the sides of the chip 50. Considering the fact that the chip 50 handled in the form of a chip carrier is often held at the sides thereof, the structure of this embodiment realizes far easier handling than bare chip packaging. Still another function achievable with this embodiment is to allow the chip 50 to be buried in the recess easily and efficiently. That is, the seal resin 56 should only be introduced in the recess of the heat spreader 52. At this instant, the resin is surely prevented from reaching the sides of the heat spreader 52. Since a resin having low viscosity can be poured into the recess of the heat spreader 52, it does not trap air bubbles. The thickness of the seal resin 56 can be controlled by the height of the "banks" surrounding the seal resin 56. The input/output terminals of the chip 50 may take the form of bumps 50b shown in FIG. 10, if desired.

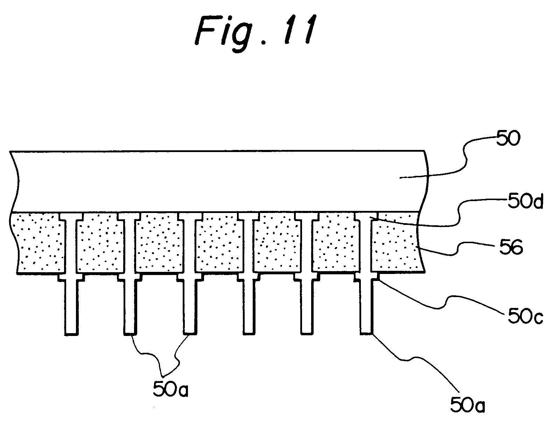

FIG. 11 shows another alternative embodiment of the present invention. As shown, the pins 50a are each provided with a flange 50c at the outside of the seal resin 56. The flange 50c has a diameter which is substantially twice as large as the diameter of the pin 50a. For example, if the pin 50a has a diameter of 0.1 millimeter, then the diameter of the flange 50c will be about 0.2 millimeter. While the flange 50c may have any desired thickness, the thickness is usually about one half of the diameter of the flange 50c. The flange has two different functions. A first function is to prevent the resin 56 from flowing out; when a varnish-like resin is potted, it is likely to flow out along the surfaces of the pins 50a due to surface tension. A second function is to prevent solder from rising along the pins 50a. Specifically, when the chip carrier is affixed to a printed circuit board or similar circuit board by solder, the solder rises along the pins 50a. Controlling the rise of the solder along the pins 50a is an important consideration. This is especially true with this embodiment having thin and short pins 50a. The flanges 50c of the pins successfuly prevent the solder from rising along the pins 50a. In FIG. 11, labeld 50d is a nail head.

In summary, in accordance with the present invention, a chip carrier has a heat spreader affixed to the rear of an IC chip, leads directly connected to the front of the chip, and, if necessary, a seal resin burying the chip in the chip carrier. The chip carrier, therefore, implements a multi-terminal configuration comparable with one particular to bare chip packaging and thereby realizes high package density. Furthermore, the chip carrier achieves a lead length, lead inductance and lead capacitance equivalent to those of bare chip packaging, thereby realizing high-speed signal propagation. The chip carrier of the invention is as easy to handle, test and seal as a conventional chip carrier and, in addition, has higher reliability (needing only one half of parts) and heat radiation ability (heat spreader defining the size of chip carrier body). Such a chip carrier has a simple structure and is cheap.

## Claims

1. A semiconductor IC chip carrier comprising:
a) a semiconductor IC chip (50);
b) input/output terminals comprising pins (50a) and being arranged on a circuit surface of said IC chip (50);
c) a heat spreader (52) affixed to a surface of said IC chip (50) opposite to said circuit surface,
d) a seal resin (56) covering part of said heat spreader (52), said IC chip (50), and part of said input/output terminals ;
characterized in that
e) each of said pins (50a) comprises a flange (50c) between opposite ends thereof, the surface of said resin (56) being positioned on said IC chip side with respect to said flange.

2. A chip carrier as claimed in claim 1, further comprising an adhering member (54) provided between said surface of said IC chip (50) opposite to said circuit surface and said heat spreader (52).

3. A carrier as claimed in claim 1 or 2, wherein said heat spreader (52) is thicker at peripheral portions thereof than at a central portion to form a recess at said central portion, said IC chip (50) being received in said recess, said seal resin (56) being provided in said recess.
